# EUROPEAN PATENT APPLICATION

(11) **EP 1 582 881 A1**
(43) Date of publication of application: **05.10.2005**
(21) Application number: 05101624.4
(22) Date of filing: 03.03.2005
(51) Int. Cl.: G01R 15/14, H01B 17/00

(54) **Measuring device for use in power distribution networks or transmission networks**

(30) Priority: 19.03.2004 FI 20045087
(71) Applicant: Ensto Sekko Oy, 06100 Porvoo (FI)
(72) Inventor: Hinkkuri, Antero, 00820, Helsinki (FI); Leskinen, Tapio, 05800, Hyvinkää (FI); Nordman, Mikael, 02130, Espoo (FI); Lehtonen, Matti, 02200, Espoo (FI)
(74) Representative: LEITZINGER OY

(57) **Abstract**

The invention relates to a measuring device (3, 5) for use in power distribution networks or transmission networks, comprising a measuring sensor (5) for measuring one or more parameters of a network and a transmitter (9) for the wireless communication of measured data. The measuring device is mountable on the top end of a power line insulator (1), such that the measuring device (3, 5) is integrated with a conductor-laying sleeve (2) installable in a channel present at the insulator's (1) top end.

## Description

The invention relates to a measuring device for use in power distribution networks or transmission networks, comprising a measuring sensor for measuring one or more parameters of a network and a transmitter for the wireless communication of measured data, said measuring device being mountable on the top end of a power line insulator.

### Background

The significance of measured data obtained from electric power distribution and transmission networks has increased dramatically over the past years. A reason for this are increasingly strict efficiency regulations in power companies, requiring a higher utilization rate of network capacity and hence more specific information about the state of a power system. As networks are aging, various measurements regarding condition supervision and diagnostics have also gained new significance.

Another essential developing trend is the supervision of power networks for reliability in operation. Since network business is monopoly-type of service, the supervising authority has developed various methods for ensuring the standard of distribution service. Since the out-of-service times of a distribution network are becoming the most essential criterion in terms of regulation, the network companies have a major economic interest to enhance the efficiency of their actions in fault situations. In practice, this means investments in network automation, i.e. malfunction indicators and remote-controlled disconnectors. However, a bottleneck in the further development of network automation has turned out to be the lack of economically sensible malfunction indicators and measured data.

The best way of responding to the above requirements would be by developing an all-round wireless sensor adaptable to medium-voltage distribution networks. Sensor technology has lately been an object of growing interest, principally because of progress in electronics and communications technology. A central contributor has been the miniaturization of electronics, which has brought along performance-enhanced circuit components with minimal energy consumption. By virtue of this progress, it has become possible to integrate a very lightweight and wireless sensor with various power network components.

Various sensor solutions have indeed been developed worldwide, ranging from "power doughnuts" (transmission line current measurement) introduced in the early 80's to a combination current measurement/fault detector introduced last spring by FMC Technology, Ireland. A common feature for both of the above solutions is the installation thereof in a suspended condition around a conductor to be measured. Being quite heavy-duty loose components, these present a discontinuity on the conductor and thereby add to the risk of the conductor snapping off as a result of wind-inflicted vibrations. Such measuring sensors have been described for example in patent publications EP-0314860, EP-0314849, EP-0125050, and US-5565783. Moreover, measurement arrangements for measuring sensors have been described for example in patent publication US-4689752 and published application WO 01/71367.

In addition to the above, measuring technology has been integrated with cable terminals and overhead line insulators. With regard to an overhead line insulator, there is a solution patented some time ago in the USA for US-6555999, wherein the measuring sensor is mounted on a pin connecting the insulator to a crossbar. The solution is elegant, yet requires earthing of the crossbar, which in turn undermines crucially the overvoltage resistance of the line. The solution is not wireless but necessitates a signal cable system, which in turn is susceptible to induced noises. Patent publication US-5124642 discloses the disposal of a sensor inside an insulator of hollow design while the insulator's top end is shaped as a conductor-receiving channel. This requires a special-made hollow insulator and the disposal of a sensor device inside the same is an awkward task in terms of manufacturing technology. Sensor solutions integrated with cable terminals have been presented for example in patent publications US-3657650 and US-6031368.

It is an object of the invention to provide a measuring device of the above-mentioned type, whereby the foregoing problems can be avoided.

This object is accomplished on the basis of the inventive characterizing features set forth in the appended claim 1. Preferred implementations and embodiments of the invention are set forth in the dependent claims.

Thus, the above-described problems can be avoided by integrating a wireless sensor device with a conductor-laying sleeve of an electric power network, typically an overhead network. This sleeve is a component which is installed in a channel present at the top end of a pin insulator for facilitating the installation of a conductor in a line building process. Generally, the conductor-laying sleeve is left in its place after installation because, by virtue of its shaping, the effects of mechanical vibrations will be less severe.

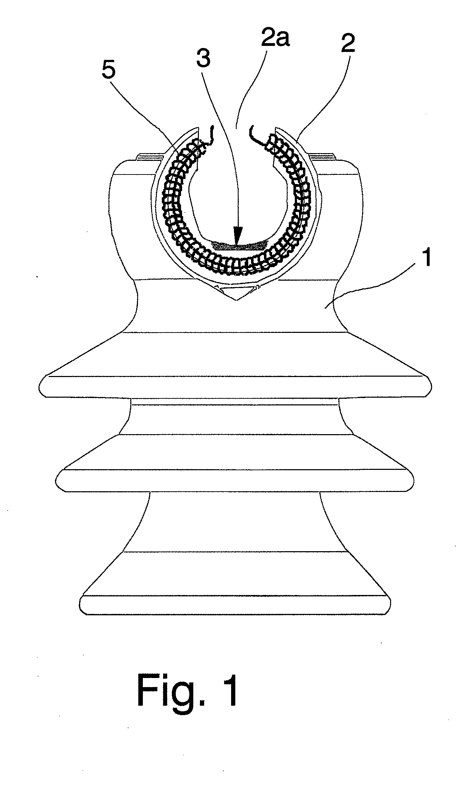

One exemplary embodiment of the invention will now be described in more detail with reference to the accompanying drawings, in which
- fig. 1: shows a measuring device 3, 5 as integrated with a conductor-laying sleeve 2 present at the top end of an insulator 1,

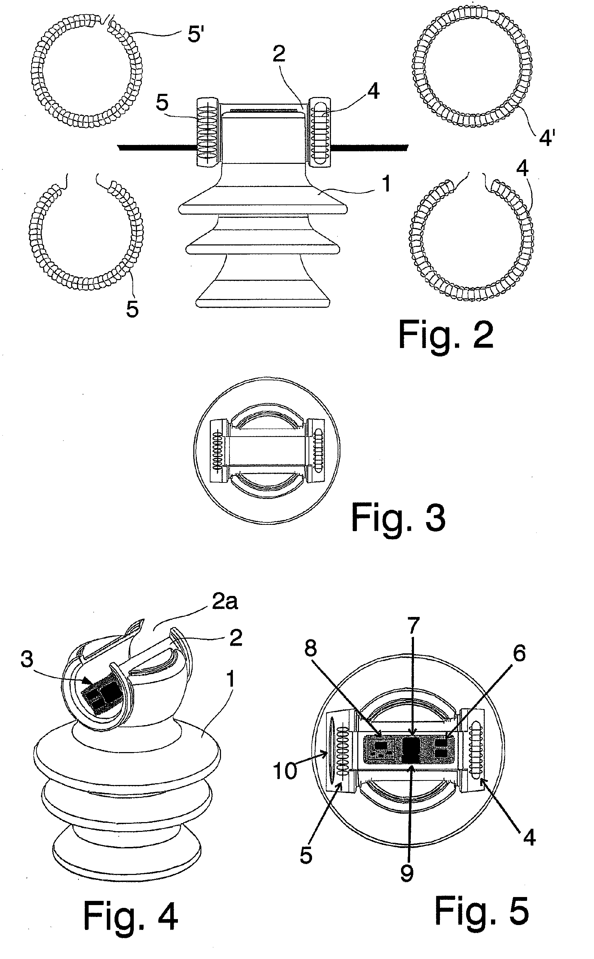

- figs. 2 and 3: show the conductor-laying sleeve present at the insulator's top end in side and plan views, respectively. Fig. 2 shows also a measuring coil 5, 5' and a power coil 4, 4' as separate components, and
- figs. 4 and 5: show the same as the preceding figures in perspective and plan views, respectively. Fig. 5 shows functional blocks for an electronics segment.

The conductor-laying sleeve 2 is made in plastics and designed as a bifurcated cylinder. By virtue of this design and material, one or more measuring sensors 5 and radio transceivers 9, along with their antennae 10, are reasonably easy to cast inside the sleeve or bond with an adhesive to the sleeve's inner or outer surface. In addition, the sleeve has a highly natural site in an overhead line, which enhances the possibilities of a sleeve-integrated measuring device to become an article of mass production. As opposed to a measuring device fitted around a transmission conductor, the measuring device integrated with a conductor laying sleeve is very lightweight in construction, because the pin insulator functions as a support structure for the measuring device, and the measuring device does not include mechanical bracing elements (prior art measuring devices are mechanically stressful because of their hot-stick principle and mechanical elements to retain the measuring device fixedly around the conductor). Neither does the sleeve present any extra discontinuity on the conductor. Compared with a measuring device integrated with an insulator pin, the conductor-laying sleeve is easier to replace.

In the depicted exemplary embodiment, the sensor comprises a measuring coil 5 (Rogowski's coil), which nevertheless is not a closed circle in terms of its core but, instead, has a gap matching a split 2a in the sleeve 2. The measuring coil 5' may also be flexible for opening and closing the gap or it can be split for two halves, which are attached with the ends against each other to the end of the sleeve 2 around a conductor. The sleeve 2 has its other end provided with a power coil 4 or 4', having a design which subject to the same comments as the measuring coil. A circuit board or some other electronics panel carries a power source 6, containing typically a large capacitor, a micro-controller 7, a filter-repeater 8 and a radio transceiver 9. This electronics segment 3 can be disposed in the region between the ends of the elongated sleeve 2. The antenna 10 can be placed at the end of the sleeve 2 alongside the measuring coil.

All above-mentioned essential parts of the device can be secured or cast in engagement with the conductor-laying sleeve 2 for protection from weather. The essential parts or some of such parts of the device can be secured or cast in engagement with a conductor-laying sleeve also for protection from power network overvoltages.

The conductor-laying sleeve 2, along with its measuring device, is installable during line construction in a channel present at the insulator's 1 top end and the sleeve has a second function of facilitating the laying of a conductor. The sleeve 2, along with its measuring device, can also be installed in the way of retrofitting when it is desirable to replace a previously installed conductor-laying sleeve with a measuring-device equipped sleeve.

The installation of a measuring device or a sensor device of the invention is easy to realize during the construction of a power line. Another characteristic of the measuring device is the fact that it is not separately fitted around a transmission or distribution conductor but, instead, the conductor is fitted inside the sensor device. The measuring device is likewise characterized by communicating measured parameters by way of radio or otherwise without a galvanic coupling to a receiving apparatus.

Functions conceivable for sensor 5 or sensors include, for example:
- measurement of conductor current, voltage and temperature
- indication of conductor break
- indication of various faulty states (short circuit, earth fault)
- measurement of wind-inflicted conductor vibration
- measurement of partial discharges in power network

### Application aspects

The consumption of energy can be decreased and the size of a power source can be reduced by minimizing measurements necessary from operational viewpoint and by synchronizing measured parameters with a current of the phase in question, as well as by measuring the current in faulty states during the fault as well as immediately prior to the fault. By comparing these two measurements to each other, it is possible to assess the fault current, along with its phase angle, at a precision sufficient in terms of fault detection.

Prior known competitive solutions have been realized by using a GPS system (FMC technology) for synchronization, by resorting to continuous measurement (EP-0314850) or by fitting a middle-phase installed sensor with extra measuring coils (WO 01/71367). The former solutions are stressful both mechanically and in terms of energy consumption while the latter is sensitive to installation geometry.

With the discussed sensor and measuring technology, the device has a capability of identifying earth fault and short-circuit currents and the device is capable of measuring partial discharges and/or conductor vibrations in a power network. If desired, the latter can be effected by using a pressure transducer as the sensor.

## Claims

1. A measuring device (3, 5) for use in power distribution networks or transmission networks, comprising a measuring sensor (5) for measuring one or more parameters of a network and a transmitter (9) for the wireless communication of measured data, said measuring device being mountable on the top end of a power line insulator (1), **characterized in that** the measuring device (3, 5) is integrated with a conductor-laying sleeve (2) installable in a channel present at the insulator's (1) top end.

2. A device as set forth in claim 1, **characterized in that** the device (3, 4, 5) has its essential parts or some of such parts bonded or cast for weather protection in engagement with the conductor-laying sleeve (2).

3. A device as set forth in claim 1 or 2, **characterized in that** the device (3, 4, 5) has its essential parts or some of such parts bonded or cast in engagement with the conductor-laying sleeve (2) for protection from power network overvoltages.

4. A device as set forth in any of claims 1-3, **characterized in that** the transmitter (9) communicates parameters measured thereby to a receiving apparatus without a galvanic coupling.

5. A device as set forth in any of claims 1-4, **characterized in that** the conductor-laying sleeve (2) is installable in a channel present at the insulator's top end during the line construction, and the sleeve (2) has a second function of facilitating the installation of a conductor.

6. A device as set forth in claim 1-4, **characterized in that** the conductor-laying sleeve (2) is installable in the way of retrofitting in a channel present at the insulator's (1) top end.

7. A device as set forth in any of claims 1-6, **characterized in that** the device has its source of energy comprising one or more of the following: the sun, wind, vibration, pressure, temperature difference, voltage or current.

8. A device as set forth in any of claims 1-6, **characterized in that** the sensor (5) measures intermittently or continuously power network and/or ambient parameters.

9. A device as set forth in claim 8, **characterized in that** the device synchronizes the measurements with a phase current and in fault situations measures the phase current both prior to and during the fault, and that the device determines the strength of fault current as a difference between these two measurements, including their phase angles.

10. A device as set forth in claim 9, **characterized in that** the device has a capability of identifying earth fault and short-circuit currents.

11. A device as set forth in claim 1, **characterized in that** the device measures partial discharges and/or conductor vibration in a power network.
